(19) Europäisches Patentamt
European Patent Office
Office européen des brevets

(11) **EP 1 852 948 A1**

(12) **EUROPEAN PATENT APPLICATION**
published in accordance with Art. 158(3) EPC

(43) Date of publication:
**07.11.2007 Bulletin 2007/45**

(51) Int Cl.:
*H01S 3/13* (2006.01)   *G03F 7/20* (2006.01)
*H01L 21/027* (2006.01)   *H01S 3/00* (2006.01)
*H01S 3/03* (2006.01)

(21) Application number: **06712636.7**

(22) Date of filing: **30.01.2006**

(86) International application number:
**PCT/JP2006/301493**

(87) International publication number:
**WO 2006/080513 (03.08.2006 Gazette 2006/31)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **31.01.2005 JP 2005024601**

(71) Applicant: **NIKON CORPORATION**
**Tokyo 100-8331 (JP)**

(72) Inventor: **ARAI, Masayoshi**
**NIKON CORPORATION Intellectual Pro -ku, Tokyo**
**1008331 (JP)**

(74) Representative: **HOFFMANN EITLE**
**Patent- und Rechtsanwälte**
**Arabellastrasse 4**
**81925 München (DE)**

(54) **LASER LIGHT SOURCE CONTROL METHOD, LASER LIGHT SOURCE DEVICE, AND EXPOSURE APPARATUS**

(57)    A control method of controlling the rotation angle and/or polarized state of a laser beam outputted from a laser light source performing pulse oscillation. In the method of controlling an excimer laser light source (8) performing pulse oscillation, a laser beam (LB) emitted by pulse oscillation from the excimer laser light source (8) is branched by a beam splitter (9) and directed to a rotation angle monitor (10). A detection/rotation computing section (11) detects the rotation angle of the profile of the laser beam (LB). A storage/correction computing section (12) controls the posture of the excimer laser light source (8) by means of a drive section (6A to 6D) so as to correct the rotation angle.

FIG. 1

## Description

TECHNICAL FIELD

The present invention relates to a method of controlling a laser light source for performing pulse oscillation, and more particularly, to a method of controlling a laser light source, which is used as an exposure light source of an exposure apparatus for transferring a mask pattern onto a substrate by a lithography process to manufacture various devices, for example, semiconductor devices, charge-coupled devices (CCD), liquid crystal displays and the like.

BACKGROUND ART

For example, in a semiconductor device fabrication process such as a lithography process, an exposure apparatus is used to transfer a pattern formed on a reticle (or a photo mask and the like) as a mask onto a wafer (or glass plate and the like) coated with resist as a substrate. Examples of the exposure apparatus include a batch exposure type (stationary exposure type) of projection exposure apparatus, such as a stepper, and a scanning exposure type of a projection exposure apparatus, such as a scanning stepper.

In such an exposure apparatus, a wavelength of an exposure light progressively becomes shorter to improve resolution. At present, a discharge excitation type of excimer laser light source performing band-narrowed pulse oscillation such as a krypton-fluoride (KrF) excimer laser (of a wavelength of 248nm) or an argon-fluoride (ArF) excimer laser (of a wavelength of 193nm), is used as an exposure light source. A laser beam emitted by the pulse oscillation from the excimer laser light source is processed to have a uniform intensity of beam (luminous intensity) in the illumination optical system of an exposure apparatus, and is emitted to a reticle. An external shape (sectional shape) of the laser beam emitted by the pulse oscillation is defined by the distance between discharge electrodes, the structure of a resonator, and the mechanical apertures and the like, and is typically defined as substantially a rectangular shape.

Further, the laser beam emitted by the pulse oscillation from the excimer laser light source generally has the characteristic of a linearly polarized light due to the structure of the resonator. An exposure apparatus has been suggested to improve, for example, resolution, in which exposure is performed by controlling a polarized state of an exposure beam (see, for example, Patent Reference 1). In this exposure apparatus, a laser beam with the characteristic of the linearly polarized light is most suitable for efficiently controlling the polarized state.

Patent Reference 1: PCT International Publication No. Wo 2004/051717

DISCLOSURE OF INVENTION

PROBLEMS TO BE SOLVED BY THE INVENTION

It is demanded that an exposure apparatus increase its throughput. To meet such a requirement, the external shape of a laser beam which is introduced to a body of an exposure apparatus needs to be, if possible, closer to the external shape of an optical member, such as a fly's-eye lens, and an excimer laser light source needs to produce high power if possible. Further, as a semiconductor device has been increasingly miniaturized, a laser beam needs to be extremely band-narrowed; the degree of a linearly polarized light needs to be increased; and the direction of the linearly polarized light of the laser beam to be introduced needs to be stabilized whenever possible.

However, an excimer laser light source and a body of an exposure apparatus are generally positioned to be spaced apart from each other, and a laser beam which is output from the excimer laser light source is sent to the body of the exposure apparatus, through a light-sending optical system which has a relatively long optical path. When the laser beam is sent to the body of the exposure apparatus, the laser beam may be slightly rotated, depending on the optical performance of the excimer laser light source and the light-sending optical system. Specifically, when increasing the power of the excimer laser light source, the external shape of the oscillated laser beam is distinguishably changed in a rotation angle, compared to a prior art. The change in the rotation angle causes deviation between the external shape of the incident laser beam and the external shape of an optical member corresponding to the external shape of the incident laser beam in the body of the exposure apparatus, thereby deteriorating the illumination efficiency.

Moreover, although, for example, maintenance of the excimer laser light source is regularly performed in the exposure apparatus, the rotation angle of the external shape of the laser beam may be changed before and after the maintenance. In this case, to prevent the deterioration of the illumination efficiency, the change in the rotation angle of the laser beam needs to be prevented.

Accordingly, it is a first object of the present invention to provide a laser technology for controlling a laser beam, which is outputted from a laser light source performing pulse oscillation in a desired condition.

Further, a second object of the present invention is to provide an exposure technology and a device fabrication technology for performing exposure with high throughput or high resolution, using the aforementioned laser technology.

MEANS FOR SOLVING THE PROBLEM

In accordance with the present invention, a first method of controlling a laser light source performing pulse oscillation, includes: a first process of detecting a rotation angle of an external shape of a laser beam emitted by the pulse oscillation from the laser light source.

In accordance with the present invention, a rotation angle of the external shape of a laser beam can be controlled, based on a detection result of the rotation angle of the external shape of the laser beam.

Further, when a change in the rotation angle of the external shape of the laser beam can be related to a change in a polarized state of the laser beam, the polarized state of the laser beam is controlled, based on the detection result of the rotation angle of the external shape of the laser beam.

In accordance with the present invention, there may be further included a second process of controlling at least any one of a rotation angle of an external shape of a laser beam, which is emitted by pulse oscillation from the laser light source and a rotation angle of a linearly polarized light component of a corresponding laser beam, based on the rotation angle which is detected in the first process.

Further, in accordance with the present invention, a second method of controlling a laser light source performing pulse oscillation includes a first process of storing in advance a relation between an operation state of the laser light source and a rotation angle of an external shape of a laser beam emitted by the pulse oscillation from the laser light source; and a second process of controlling at least any one of a rotation angle of an external shape of a laser beam emitted by pulse oscillation from the laser light source and a rotation angle of a linearly polarized light component of a corresponding laser beam, based on the relation being stored in the first process.

In accordance with the present invention, a rotation angle of a laser beam is predicted in a second process, based on a memorized relation. Therefore, the rotation angle, a polarized state, or both the rotation angle and the polarized state of the laser beam are accurately controlled, based on a prediction result.

In accordance with the present invention, a first laser light source device having a laser light source that performs pulse oscillation includes a detection system that detects a rotation angle of an external shape of a laser beam emitted by the pulse oscillation from the laser light source.

In accordance with the present invention, a rotation angle, a polarized state, or both the rotation angle and the polarized state of a laser beam are controlled, based on a detection result of the rotation angle of the external shape of the laser beam.

In accordance with the present invention, there may be further included a control device that controls at least any one of a rotation angle of an external shape of a laser beam emitted by pulse oscillation from the laser light source and a rotation angle of a linearly polarized light component of a corresponding laser beam, based on the rotation angle detected by the detection system.

In accordance with the present invention, a second laser light source device having a laser light source performing pulse oscillation includes a memory device that stores a relation between an operation state of the laser light source and a rotation angle of an external shape of a laser beam emitted by the pulse oscillation from the laser light source; and a controlling device that controls at least any one of a rotation angle of an external shape of a laser beam emitted by pulse oscillation from the laser light source and a rotation angle of a linearly polarized light component of a corresponding laser beam, based on the relation stored in the memory device.

In accordance with the present invention, a rotation angle of a laser beam is predicted, based on a memorized relation. Further, the rotation angle, a polarized state, or both the rotation angle and the polarized state of the laser beam are accurately controlled, based on the rotation angle of the laser beam.

In accordance with the present invention, the control device may include, as an example, a holding structure that holds the laser light source, and a driving structure that controls orientation of a corresponding holding structure.

Further, the control device may include, as another example, a wavelength plate which is positioned on an optical path of the laser beam emitted by the pulse oscillation from the laser light source.

In accordance with the present invention, a first exposure apparatus is an exposure apparatus which exposes an object with an exposure beam, wherein the exposure beam is emitted to the object and is a laser beam being output from the laser light source device according to the present invention.

In accordance with the present invention, a rotation angle of a laser beam can be controlled to increase throughput, and a direction of a linearly polarized light component of the laser beam can be controlled to increase resolution.

In accordance with the present invention, a second exposure apparatus which exposes an object by emitting an exposure beam to a corresponding object includes a laser light source that emits a laser beam as the exposure beam by pulse oscillation; a detection system that detects a rotation angle of an external shape of the laser beam emitted by the pulse oscillation from a corresponding laser light source; and a control device that controls at least any one of a rotation angle of the external shape of the laser beam and a rotation angle of a linearly polarized light component of a corresponding laser beam, based on the rotation angle detected by the detection system.

In accordance with the present invention, a rotation angle of a laser beam is controlled to increase throughput, and a direction of a linearly polarized light component of the laser beam is controlled to increase resolution.

In accordance with the present invention, there may be further included an illumination optical system that emits the laser beam to a predetermined pattern, wherein the detection system that detects the rotation angle of the external shape of the laser beam is disposed to be proximate to a position where the laser beam is incident on the illumination optical system.

In accordance with the present invention, a third exposure apparatus which exposes an object by emitting an exposure beam to a corresponding object includes a laser light source emitting a laser beam as the exposure beam by pulse oscillation; and a control device that controls at least any one of a rotation angle of an external shape of the laser beam and a rotation angle of a linearly polarized light component of a corresponding laser beam, based on an operation state of the laser light source.

In accordance with the present invention, a rotation angle, a polarized state, or both the rotation angle and the polarized state of a laser beam are controlled, based on a rotation angle which is predicted depending on an operation state.

In accordance with the present invention, a device fabricating method uses the exposure apparatus according to the present invention.

BRIEF DESCRIPTION OF THE DRAWINGS

FIG 1 is a sectional view of a laser light source device according to a first embodiment of the present invention.

FIG 2 is a side view of an excimer laser light source 8 of FIG 1 in view of an emission surface of a laser beam LB.

FIG 3 part (A) is a view of a pair of line sensors 13A and 13B which are positioned on a light-receiving surface of a rotation angle monitor 10 of FIG 1, and part (B) is a view illustrating that the incident laser beam LB is rotated in the constitution of FIG. 3 part (A).

FIG 4 part (A) and part (B) are views of detection signals of the line sensors 13A and 13B of FIG 3 part (A); and FIG 4 part (C) and part (D) are views of detection signals of the line sensors 13A and 13B of FIG 3 part (B).

FIG 5 is a view illustrating that the external shape of the laser beam LB (LB1) of FIG 1 is gradually changed, depending on an operation state of the excimer light source 8.

FIG 6 part (A) is a view of an example of the constitution in which one line sensor 13A is positioned on the light-receiving surface of the rotation angle monitor 10 of FIG 1, and part (B) is a view of an example of the constitution in which an area sensor 14 is positioned on the light-receiving surface of the rotation angle monitor 10.

FIG 7 part (A) is a view illustrating the state that an aperture plate 7A is positioned on an emission surface of a frame 4 of FIG 1, and part (B) is a view of the external surface of the laser beam LB 1 which is incident on the light-receiving surface of the rotation angle monitor 10 of FIG. 1.

FIG 8 is a schematic view of the constitution of a projection exposure apparatus according to a second embodiment of the present invention.

FIG 9 part (A) is a view for explaining a rotation angle of a 1/2 wavelength plate 18 of FIG 8 when generating an exposure light of a linearly polarized light, and part (B) is a view illustrating a relation between the 1/2 wavelength plate 18 and a 1/4 wavelength plate 19 of FIG 8 when generating an exposure light of a circular polarized light.

DESCRIPTION OF THE REFERENCE SYMBOLS

1 : discharge chamber, 2 : partial reflection mirror, 3 : entire reflection mirror, 4 : frame, 6A~6D : driving units, 7, 7A : aperture plate, 8 : excimer laser light source, 9, 17 : beam splitter, 10, 10A : rotation angle monitor, 11, 11 A : detection/rotation calculating unit, 12, 12A: memory/correction calculating unit, 13A, 13B : line sensors, 14 : area sensor, 18 : 1/2 wavelength plate, 19 : 1/4 wavelength plate, 21 : memory device, 22 : illumination optical system, 32 : main control system, 33 : light source control system, R : reticle, PL: projection optical system, W : wafer

BEST MODE FOR CARRYING OUT THE INVENTION

<First Embodiment>

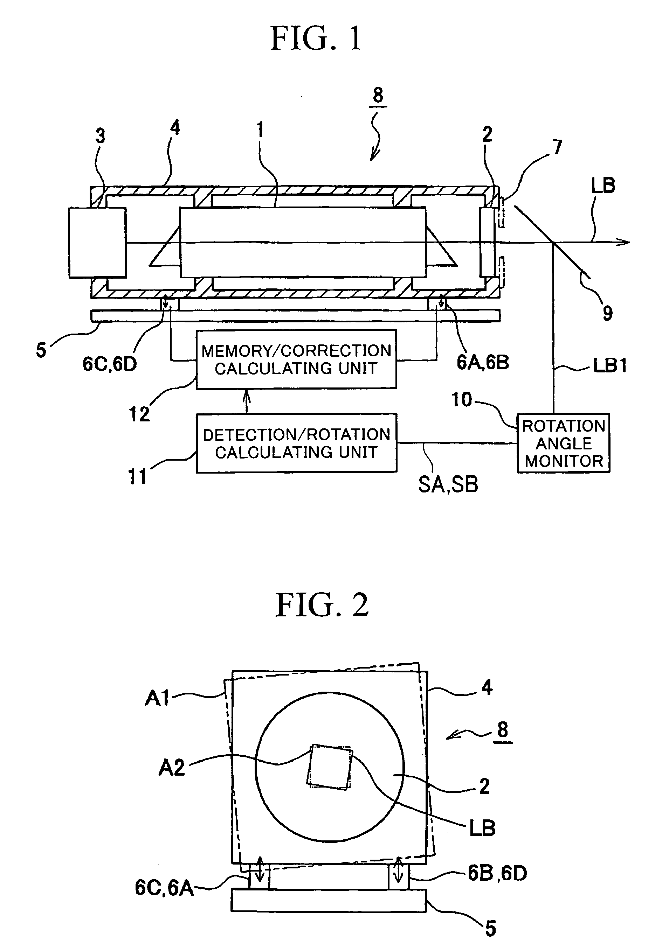

A first embodiment of the present invention will be described with reference to FIGS. 1 through 7. In the first embodiment, the present invention is applied to a laser light source device producing pulse oscillation.

FIG 1 is a sectional view of an excimer laser light source device as the laser light source device of the first embodiment. In FIG. 1, a discharge excitation type of excimer laser light source 8 performing band-narrowed pulse oscillation includes: a discharge chamber 1 including an ArF excimer laser (of an oscillation wavelength of 193nm) or a KrF excimer laser (of an oscillation wavelength of 248nm), a partial reflection mirror 2 positioned at a front side of the discharge chamber 1, and an entire reflection mirror 3 positioned at a back side of the discharge chamber 1, wherein the discharge chamber 1, the partial reflection mirror 2 and the entire reflection mirror 3 are fixed at a predetermined position on a frame 4. Oscillation frequency and oscillation power (pulse energy) of the excimer laser light source 8 are controlled by a light source control system (not shown). The oscillation frequency is, for example, about 4 to 6 kHz. A laser beam LB is outputted from the partial reflection mirror 2 to the exterior, and the external shape, i.e., sectional shape, of the laser beam LB is rectangular with about 20mm in square. When the laser beam LB has no positional deviation in design and no change of a rotation angle (that is, a reference state), an optical axis of the laser beam LB is parallel to the paper plane of FIG 1. Further, an aperture plate 7 with a rectangular aperture to form the external shape of the laser beam LB may be positioned at an output unit of the laser beam LB of the frame 4. Further, the sectional shape as the external shape of the laser beam LB may be rectangular, circular or oval.

The frame 4 of the excimer laser light source 8 is positioned on a base member 5 through four driving units 6A, 6B, 6C and 6D which are vertically movable. At least parts of a structure for controlling the rotation angle of the laser beam are formed with the frame 4 and the driving units 6A, 6B, 6C and 6D. The driving units 6A and 6B and the driving units 6C and 6D are spaced apart from one another, at a predetermined interval, and positioned in a direction perpendicular to the paper plane of FIG. 1.

FIG 2 is a side view of the excimer laser light source 8 of FIG. 1 in view of an emission surface of the laser beam LB. The rotation angle of the excimer laser light source 8 and furthermore, the rotation angle of the sectional shape of the laser beam LB are controlled by allowing a sign of the driving extent of the driving units 6B and 6D positioned at the right side relative to FIG 2 to be opposite to that of the driving extent of driving units 6A and 6C positioned at the left side relative to FIG. 2. The frame 4 and furthermore, the orientation of the excimer laser light source 8 can be controlled by the driving units 6A, 6B, 6C and 6D positioned at four places, and the rotation angle around the optical axis of the laser beam LB can be controlled. The driving extent of the driving units 6A, 6B, 6C and 6D is controlled by a memory/correction calculating unit 12 shown in FIG 1.

Referring back to FIG 1, the laser beam LB emitted by pulse oscillation from the excimer laser light source 8 is incident on a beam splitter 9 having low reflectivity. Most of the laser beam LB transmitted through the beam splitter 9 is towards an illumination optical system of a projection exposure apparatus (not shown). A laser beam LB1 having some intensity of radiation, which is divided from the laser beam LB by the beam splitter 9, is incident on a light-receiving unit of a rotation angle monitor 10 as a detection system for detecting the rotation angle by the external shape of the laser beam LB1 (furthermore, the laser beam LB).

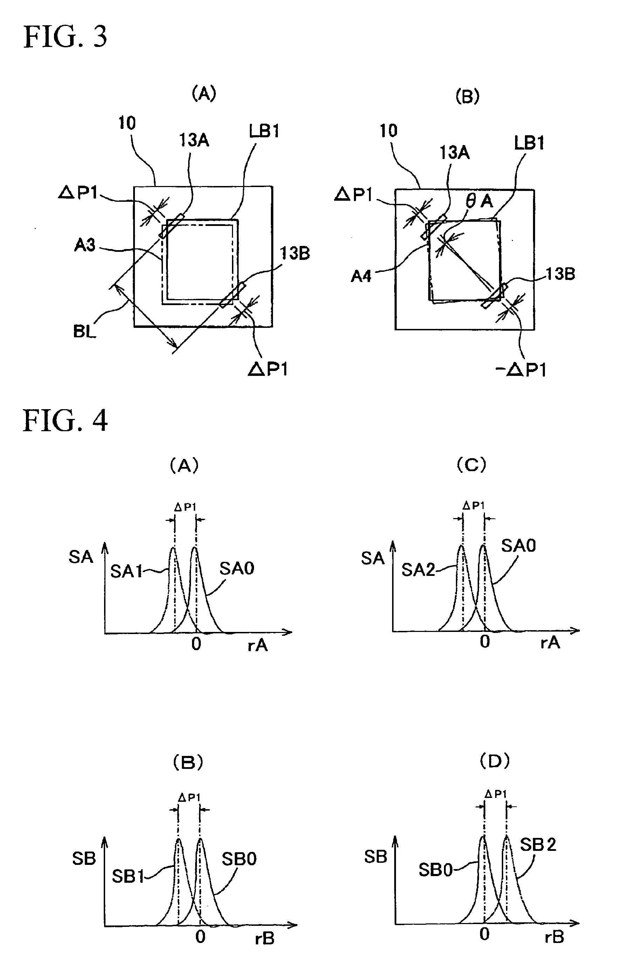

Part (A) of FIG 3 shows the light-receiving unit of the rotation angle monitor 10. In part (A) of FIG 3, the laser beam LB 1 which is nearly rectangular in external shape enters the light-receiving unit. As the laser beam LB 1 is in the reference state, a pair of line sensors 13A and 13B (one-dimensional sensors) are respectively positioned at the slightly inward sides of a pair of angular points, which are opposite to one another, of the laser beam LB 1, so that they are along a measurement direction perpendicular to a diagonal connecting the pair of the angular points to each other, and that the distance between them is BL in a direction of the diagonal. For example, in a charge-coupled device (CCD), a length of the light-receiving unit of the line sensors 13A and 13B is set substantially as a length crossing the external shape around the angular points of the laser beam LB1. Detection signals SA and SB, which are read from a series of pixels of the line sensors 13A and 13B, are supplied to a signal processing unit inside the rotation angle monitor 10, to be converted into digital signals according to positions of the measurement direction. The digitalized detection signals SA and SB are supplied to a detection/rotation calculating unit 11 of FIG. 1.

In the detection/rotation calculating unit 11, for example, peak positions of the detection signals SA and SB are regarded as the positions of the opposite angular points of the laser beam LB 1, and the rotation angle $\theta$A of the external shape of the laser beam LB 1 is calculated by considering the positions of the angular points. In this case, when the displacement vector from the reference position (the origin) of the peak positions in the measurement direction of the detection signals SA and SB are rA and rB, the detection/rotation calculating unit 11 calculates the rotation angle $\theta$A of the laser beam LB1 (furthermore, the laser beam LB) from the following Formula, by using the distance BL between the line sensors 13A and 13B of part (A) of FIG 3:

$$\theta A = \arcsin\{(rA-rB)/BL\}\ldots\ldots(1)$$

This means that the sign of the rotation angle $\theta$A equals to a value derived by dividing the difference of the displacement vector between the peak positions, which are detected by the two line sensors 13A and 13B, by the distance BL. Further, the maximum value of the rotation angle $\theta$A of the laser beam LB 1 is considered within a range of about $\pm5°$ at present. However, within the aforementioned range, instead of Formula (1), (rA-rB)/BL may be considered proximately as a rotation angle $\theta$A [rad].

Further, in the line sensors which are generally usable, read frequency (response frequency) of a detection signal from a series of pixels is possible up to about 10kHz. When the pulse frequency of the laser beam LB is about 4 to 6kHz, the rotation angle $\theta$A of the laser beam LB1 is calculated, per pulse, derived from Formula (1). Thus, the read frequency of the line sensors 13A and 13B is also set as about 10kHz, the detection/rotation calculating unit 11 calculates the rotation angle $\theta$A per pulse emission of the laser beam LB. Further, the rotation angle $\theta$A may be calculated, for example, per several pulse emission of the laser beam LB.

Specifically, in part (A) and part (B) of FIG. 4, the horizontal axes respectively indicate the displacement vector rA and rB of the peak positions of the detection signals SA and SB of the line sensors 13A and 13B of part (A) of FIG. 3, and the vertical axes respectively indicate the diction signals SA and SB. When the laser beam LB 1 is in the reference state shown as a continuous line in part (A) of FIG. 3, the detection signals SA and SB are represented as waveforms SA0 and SB0 in the continuous line, and the displacement vector rA and rB are respectively zero (the origin). However, when the laser beam LB1 is translated parallel to a position A3, shown as a chain double-dashed line in part (A) of FIG. 3, by ∆P1, the detection signals SA and SB are represented as waveforms SA1 and SB1 in dotted line of parts (A) and (B) of FIG 4, and the displacement vector rA and rB are respectively ∆P1. When the displacement vector is plugged into Formula (1), the rotation angle θA is zero (0). That is, the effect of the parallel translation of the laser beam LB1 is removed, by using the pair of line sensors 13A and 13B positioned like part (A) of FIG 3.

Part (C) and part (D) of FIG. 4 respectively illustrate the displacement vector rA and rB of the peak positions for the detection signals SA and SB of the line sensors 13A and 13B shown in part (A) of FIG 3. When the laser beam LB1 is in the reference state shown as a continuous line in part (B) of FIG. 3, the detection signals SA and SB are represented as waveforms SA0 and SB0 in the continuous line (with the zero displacement vector rA and rB). However, the laser beam LB 1 is rotated at the rotation angle of θA and is translated to a position A4, shown as a chain double-dashed line in part (B) of FIG. 3, the detection signals SA and SB shown in parts (C) and (D) of FIG. 4 are respectively represented as waveforms SA2 and SB2 shown as a dotted line, wherein the respective displacement vector rA and rB are ∆P1 and -∆P1. When the displacement vector is plugged into Formula (1), the rotation angle θA is arcsin(2·∆P1/BL), thereby accurately calculating the rotation angle of the laser beam LB1 (first process).

The detection/rotation calculating unit 11 of FIG. 1 supplies information of the calculated rotation angle θA of the laser beam LB1 (furthermore, the laser beam LB) to the memory/correction calculating unit 12. For example, the memory/correction calculating unit 12 drives the driving units 6A, 6B, 6C and 6D so that the external shape of the excimer laser light source 8 is reversely rotated to a position A1, shown as a chain double-dashed line, to offset the rotation angle θA as shown in FIG 2. Then, the rotation angle of the laser beam LB returns to the reference state indicated as a position A2, shown as a chain double-dashed line (second process). Accordingly, the loss of radiation in the illumination optical system (not shown), to which the laser beam LB of FIG 1 is supplied, is minimized and the efficiency in using the laser beam LB is therefore increased improving throughput, for example, in an exposure process.

Further, the laser beam LB of FIG 1 is emitted as a linearly polarized light from the excimer laser light source 8. The polarization direction of the linearly polarized light component is parallel to, for example, one side of the rectangular section of the laser beam LB. Thus, when the rotation angle of the external shape of the laser beam LB1 (LB) is detected, the polarization direction of the linearly polarized light component may be controlled to offset the detected rotation angle, without correcting the rotation angle of the external shape of the laser beam LB. For this control, for example, a 1/2 wavelength plate may be used. When the polarization direction of the laser beam LB is important in use, the 1/2 wavelength plate is used to maintain the polarization direction as the reference direction. Further, the rotation control of the external shape of the laser beam LB may be made together with the rotation control of the polarization direction of the linearly polarized light component.

Further, when optical parts of the excimer laser light source device are replaced for maintenance, the rotation angle of the laser beam LB is likely to be changed before and after the maintenance. Thus, after the maintenance, preferably, the rotation angle of the laser beam LB 1 may be detected, and the rotation angle of the external shape of the laser beam LB may be controlled to be in the reference state, based on a detection result. Then, the polarization direction of the linearly polarized light component of the laser beam LB may be controlled. Alternatively, both of the rotation angle and the polarization direction may be controlled.

Further, as an independent operation, a function of, for example, an emission time may be found in advance, by measuring a relation between an operation state (at least any one of pulse oscillation frequency and pulse energy) of the excimer laser light source 8 and the rotation angle of the external shape of the laser beam LB which is outputted from the excimer laser light source 8. The relation between the operation state of the excimer laser light source 8 and the rotation angle of the external shape of the laser beam LB may be stored in the memory/correction calculating unit 12 of FIG. 1 (first process).

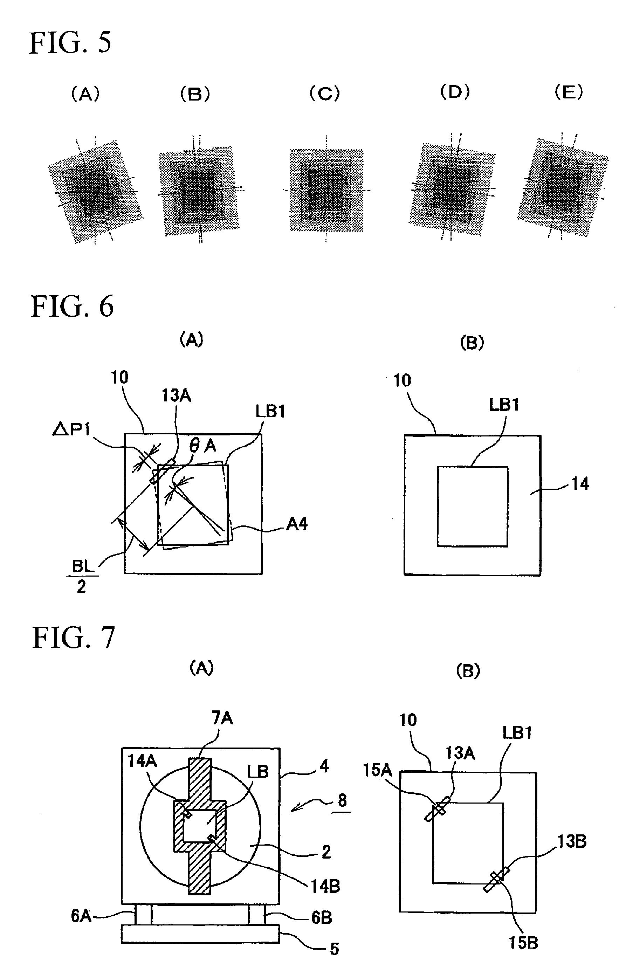

FIG. 5 is a view illustrating an example of changes in the rotation angle of the laser beam LB. For example, in any operation state, as the emission time passes, the rotation angle of the laser beam LB is substantially continuously changed as shown in parts (A), (B), (C), (D) and (E) of FIG 5. The changes of the rotation angle of the laser beam LB are stored as the function of the operation state and the emission time.

In this case, the changes of the rotation angle of the laser beam LB may be stored as the function of each operation state and emission time, by setting a plurality of operation states of the excimer laser light source 8. The plurality of operation states may include, for example, a combination of a plurality of pulse oscillation frequency and a plurality of pulse energy. Further, the changes of the rotation angle of the laser beam may be detected by changing the operation states per predetermined emission time, and the detected changes of the rotation angle may be stored as a function of the operation state and emission time being progressively changed.

Then, upon emission in the operation states of regularly or progressively changing the excimer laser light source 8, a controller of the memory/correction calculating unit 12 specifies a most suitable relation between the operation state and the emission time, from the relations being stored at predetermined time intervals. Based on the specified relation and emission time, the extent of change of the rotation angle is predicted from the reference state of the rotation angle of the external shape of the laser beam LB, and the orientation of the excimer laser light source 8 is controlled to offset the predicted extent of change of the rotation angle (second process). Then, the rotation angle of the linearly polarized light component of the laser beam LB may be controlled, independently from the control of the rotation angle of the laser beam LB or together with the control of the rotation angle thereof. Thereby, the rotation angle of the external shape of the laser beam LB emitted from the excimer laser light source 8, and the polarization direction of the linearly polarized light component are maintained substantially in the reference state, without using the rotation angle monitor 10.

Further, when at least any one of the rotation angle and the polarized state of the laser beam LB is controlled based on the information stored in the memory/correction calculating unit 12, the rotation angle monitor 10 may not be provided. Further, when the rotation angle monitor 10 is mounted, the information of changes of the rotation angle for the laser beam LB depending on the operation states may not be stored in the memory/correction calculating unit 12. At least any one of the rotation angle and the polarized state of the laser beam LB may be controlled, by using both of the detection result of the rotation angle monitor 10 and the information of changes of the rotation angle which is stored in the memory/correction calculating unit 12.

Further, the number, arrangement, and kind of sensors in the rotation angle monitor 10 are not limited to the foregoing. In the embodiment, a pair of the line sensors 13A and 13B are positioned on the light-receiving surface of the rotation angle monitor 10. However, as illustrated in part (A) of FIG 6, one line sensor 13A may be positioned on the light-receiving surface of the rotation angle monitor 10, for example, so as to obliquely cross around an angular point of the laser beam LB1 which is in the reference state. In this constitution, when the displacement vector of the peak position of the detection signal SA of the line sensor 13A is rA and the distance from the center of the laser beam LB1 to the line sensor 13A is BL/2, the rotation angle $\theta A$ of the laser beam LB1 is calculated from the following formula.

$$\theta A = \arcsin(2 \cdot rA/BL)\ldots\ldots(2)$$

Specifically, when the external shape of the laser beam LB 1 is rotated at the rotation angle of $\theta A$ and is translated to a position A4 shown as a chain double-dashed line in part (A) of FIG. 6, the displacement vector rA of the waveform of the detection signal SA of the line sensor 13A is $\Delta P1$. When the displacement vector is plugged into Formula (2), the rotation angle $\theta A$ equals to $\arcsin(2 \cdot \Delta P1/BL)$, thereby accurately finding the rotation angle of the laser beam LB 1. The constitution of the rotation angle monitor 10 shown in part (A) of FIG. 6 is simple but it is difficult to identify the parallel translation and the rotation of the laser beam LB1.

Further, as illustrated in part (B) of FIG. 6, an area sensor 14 (two-dimensional sensor), such as a two-dimensional CCD sensor, may be positioned on the light-receiving surface of the rotation angle monitor 10. The rotation angle of the external shape of the laser beam LB 1 and the center position are found, by processing an image signal of the area sensor 14. When the area sensor 14 is used as the rotation angle monitor 10, the rotation angle is detected per predetermined pulse of the laser beam LB, according to a frame rate of the area sensor 14.

Further, when the external shape (sectional shape) of the laser beam LB emitted by the pulse from the excimer laser light source 8 of FIG 1 is changed per pulse, it is preferable that the line sensors 13A and 13B with high response frequency may be used as the sensor of the rotation angle monitor 10, like the embodiment of the present invention.

Further, specifically, when the line sensors 13A and 13B (one-dimensional sensor) are used, a marking unit may be provided in the external shape of the laser beam LB1, thereby decreasing errors caused by a change of energy distribution within the laser beam LB1 and easily processing signals.

Part (A) of FIG 7 is a view illustrating an example of the aperture plate 7A of the emission side of the excimer laser light source 8 of FIG 1 when the marking unit is provided on the external shape of the laser beam LB 1. In part (A) of FIG. 7, the aperture plate 7A includes protrusions 14A and 14B which are opposite to each other in a diagonal direction in a rectangular aperture. Depressed areas 15A and 15B of intensity distribution (distribution of luminous intensity) are formed on the sectional shape of the laser beam LB 1 emitted onto the line sensors 13A and 13B on the light-receiving surface of the rotation angle monitor 10 of FIG 1. Accordingly, when the detection signals of the line sensors 13A and 13B are processed, the rotation angle of the laser beam LB 1 is found, with high accuracy, by considering, for example, valley shaped portions of the detection signals as opposite angular point positions of the laser beam LB 1.

Further, when the laser light source device of FIG 1 includes a polarization monitor for detecting the polarized state of the laser beam LB, the rotation angle of the external shape of the laser beam LB may be controlled, based on the output of the polarization monitor. In this case, the rotation angle of the external shape of the laser beam LB may be controlled by using the detection result of the polarization monitor and the detection result of the rotation angle monitor 10.

Further, the reference state of the rotation angle of the laser beam LB may suitably be set. For example, the reference state may be the rotation angle at which the polarization direction of the linearly polarized light component of the laser beam LB is in a predetermined state, or the reference state may be the rotation angle at which the energy of the laser beam LB is maximum by changing the rotation angle of the laser beam LB and monitoring the energy of the laser beam LB at a predetermined position within the optical system to which the laser beam LB is supplied.

In the embodiment, for example, after the maintenance of the laser light source device, the rotation angle of the laser beam LB is detected, and at least any one of the rotation angle and the polarized state of the laser beam LB is controlled based on the detection result. However, the timing for the control may be properly determined, that is, the time for the control may be at ordinary times or per predetermined times. Further, after the rotation angle of the laser beam LB is detected, the control based on the detection result does not have to be performed. For example, the rotation angle of the laser beam LB is detected at ordinary times, and, when the rotation angle is in excess of a predetermined permissible degree, at least any one of the rotation angle and the polarized state of the laser beam LB may be controlled.

Further, although the excimer laser light source is employed in the embodiment of the present invention, harmonic generating devices including F2 laser (wavelength of 157nm), Kr2 laser (wavelength of 146nm) and YAG laser, or harmonic generating devices including solid laser (semiconductor laser and the like) may be employed when controlling the rotation angle and/or the polarized state of the laser beam in a general light source for emitting by pulse.

<Second Embodiment>

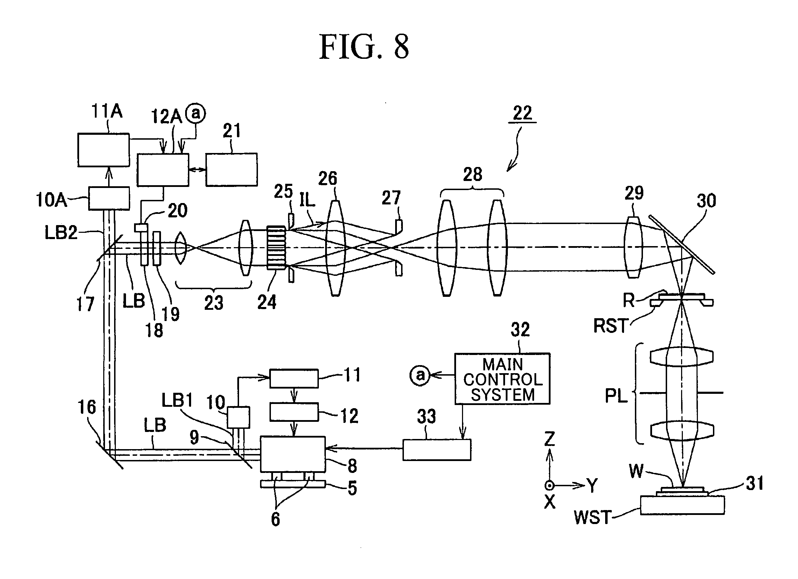

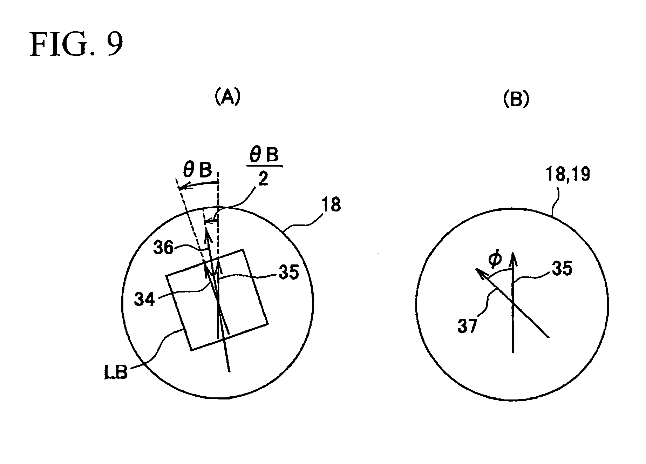

A second embodiment of the present invention will be described with reference to FIGS. 8 and 9. In the second embodiment, the present invention is applied to a projection exposure apparatus (exposure apparatus) in which a laser light source performing pulse emission is used as an exposure light source. In FIG 8, the parts corresponding to those of FIG. 1 are indicated by same reference numerals. Description of the identical parts is omitted.

FIG 8 is a schematic view of the constitution of the projection exposure apparatus in a scan exposure type, using a scanning stepper. In FIG 8, the exposure light source uses an excimer laser light source 8. A laser beam LB emitted from the excimer laser light source 8 is incident on a beam splitter 9. A rotation angle of the external shape of a laser beam LB1 which is reflected from the beam splitter 9 is detected at a predetermined sampling rate, through a rotation angle monitor 10 and a detection/rotation calculating unit 11. Based on the diction result, a memory/correction calculating unit 12 controls the orientation of the excimer laser light source 8, through driving units 6 (corresponding to the driving units 6A, 6B, 6C and 6D of FIG 1). Accordingly, the rotation angle of the external shape of the laser beam LB which is incident on the beam splitter 9 is maintained in a predetermined reference state.

The laser beam LB, which is transmitted through the beam splitter 9, passes through a light-sending optical system including a mirror 16 and is incident on another beam splitter 17 having high reflectivity. The laser beam LB reflected from the beam splitter 17 is incident on an illumination optical system 22 of the projection exposure apparatus, through a 1/2 wavelength plate 18 and a 1/4 wavelength plate 19 (wherein the 1/4 wavelength plate 19 is advantageously inserted or removed).

The laser beam LB2, which is transmitted through the beam splitter 17, is incident on a rotation angle monitor 10A (a detection system). Like the rotation angle monitor 10, the rotation angle monitor 10A supplies a detection signal according to the rotation angle of the external shape of the incident laser beam LB2, to a detection/rotation calculating unit 11a. Like the detection/rotation calculating unit 11, the detection/rotation calculating unit 11a finds a rotation angle θB from the reference state of the external shape of the laser beam LB2, from the detection signal, and supplies the rotation angle θB to a memory/correction calculating unit 12A. The memory/correction calculating unit 12A rotates the 1/2 wavelength plate 18 (wavelength plate) through a rotation driving unit 20, to rotate a linearly polarized light component of the laser beam LB so as to offset the rotation angle θB (This will be described later.). At least parts of a device for controlling the polarized state of the laser beam LB are formed from the rotation driving unit 20 and the 1/2 wavelength plate 18. Further, like the aforementioned embodiment, the memory/correction calculating unit 12A is connected to a memory device 21. The memory device 21 stores a relation between an operation state (for example, including a plurality of operation states) of the excimer laser light source 8 and the rotation angle of the external shape of the laser beam LB2 as a function of an emission time and the like. The memory/correction calculating unit 12A predicts the rotation angle θB of the external shape of the laser beam LB2, based on the relation being read from the memory device 21 if needed, and rotates the 1/2 wavelength plate 18 through the rotation driving unit 20, based on the prediction result. Further, information, such as, for example, the emission time of the excimer laser light source 8, is supplied from a main control system 32, which controls the operation of the entire apparatus, to the memory/correction calculating unit 12A.

Moreover, like the first embodiment, when the polarized state of the laser beam LB is controlled based on the information stored in the memory/correction calculating unit 12A, the rotation angle monitor 10A may not be provided. Further, when the rotation angle monitor 10A is mounted, the information of changes of the rotation angle of the laser beam LB according to the operation states may not be stored in the memory/correction calculating unit 12. The polarized state of the laser beam LB may be controlled by using both of the detection result of the rotation angle monitor 10A and the information of changes stored in the memory/correction calculating unit 12A.

The laser beam LB, which is transmitted through the 1/4 wavelength plate 19, passes through a beam formation system 23 and is incident on a fly-eye lens 24 as an optical integrator (uniformizer or homogenizer). A diffraction optical device may be used instead of the fly-eye lens 24. An aperture stop plate 25 is positioned on an emission surface of the fly-eye lens 24, that is, a pupil surface of the illumination optical system. The aperture stop plate 25 normally includes the circular aperture stop for illumination, an aperture stop for band-shaped illumination, an aperture stop for modified illumination including a plurality (for example, two-pole or four-pole) of eccentric small apertures, and a circular small aperture stop for a low coherence coefficient (σ value), which are changeably positioned. The main control system 32 positions the aperture stop, which is selected from the aperture stop plate 25, on the emission surface via a driving structure (not shown), thereby setting illumination conditions.

As an exposure light IL (exposure beam), the laser beam LB, which is emitted from the fly-eye lens 24 and passes through a predetermined aperture stop among the aperture stop plate 25, is incident on an illumination system blind 27, through a lens system 26. The illumination system blind 27 includes a fixed blind (a fixed field stop for illumination) and a movable blind (a movable field stop for illumination). The movable blind is positioned on a conjugate plane of a pattern plane (a reticle plane) of a reticle R. The fixed blind is positioned on a plane which is defocused from the conjugate plane at a predetermined degree. For example, as disclosed in Japanese Patent Application, Publication No. H04-196513, the fixed blind has an aperture which is positioned to expand in a linear slit shape or a rectangular shape (hereinafter, referred to only as 'slit shape') in a direction which is at right angles to a scanning direction in the middle of a circular field of a projection optical system PL. Further, the movable blind is used to vary the scanning direction and non-scanning direction of an illumination region in width, thereby preventing unnecessary exposure upon start and end of the scan exposure in each shot region on a waver W.

The exposure light IL, which passes through the illumination system blind 27, illuminates the illumination region of the pattern surface of the reticle R as a mask, through a first condenser lens system 28, a second condenser lens system 29, and a mirror 30 for bending an optical path (for folding the optical path to be bent). The illumination optical system 22 is formed, including the members from the beam formation system 23 to the mirror 30.

Under the exposure light IL, an image of a circuit pattern within the illumination region of the reticle R is transferred to the exposure region in the slit shape on a resist layer of one shot region on the wafer W, as a substrate (an object) which is positioned on an image formation plane of the projection optical system PL, at a predetermined projection magnification β (wherein β is, e.g., 1/4, 1/5 and the like), through the projection optical system PL with both sides (or one side) being telecentric. The reticle R and the wafer W may be respectively regarded as a first and a second object (photosensitive member). Hereinafter, the Z axis is defined being parallel to an optical axis of the projection optical system PL, the Y axis is taken in the scanning direction (here, the direction parallel to the paper plane of FIG. 8) in a plane perpendicular to the Z axis, and the X axis is taken in the non-scanning direction (here, the direction perpendicular to the paper plane of FIG 8) which is at right angles to the scanning direction.

In FIG 8, the reticle R is adsorbed on a retaining surface of a reticle stage RST, to be retained. The reticle stage RST is mounted on a reticle base (not shown), for uniform motion in the Y direction and simultaneously for slight motion in the X, Y and rotation directions. A two-dimensional position of the reticle stage RST (reticle R) is measured in real-time by a laser interference system (not shown). Based on the measurement result, the main control system 32 controls the operation of the reticle stage RST by a stage driving system (not shown).

The wafer W is adsorbed on a wafer stage WST by a wafer holder 31, to be maintained. The wafer stage WST is two-dimensionally moved on a wafer base (not shown), along the XY plane parallel to an image plane of the projection optical system PL. The laser interference system (not shown) measures, in real-time, the positions of the X and Y directions of the wafer stage WST, and the rotation angle around the X, Y and Z axes. Based on the measurement result, the main control system 32 controls the operation of the wafer stage WST by the stage driving system (not shown). Further, an alignment sensor (not shown) performing alignment of a reticle R and a wafer W is provided. Further, based on a detection result of a sensor (an integrator sensor) (not shown) for monitoring the intensity of radiation of the exposure light IL, the main control system 32 controls at least any one of pulse oscillation frequency and pulse energy of the excimer laser light source 8 by a light source control system 33, to obtain the optimum luminous intensity on the wafer W.

Upon exposure, there are performed two operations, which are repeated by a step and scan method. One operation is synchronized motion of the reticle R and the wafer W through the reticle stage RST and the wafer stage WST, at a velocity ratio of the projection magnification to the projection optical system PL, by emitting the exposure light IL (laser beam LB) to the reticle R. The other operation is step motion of the wafer W, by stopping the emission of the exposure light IL and driving the wafer stage WST. By these operations, the pattern image of the reticle R is transferred and exposed onto the entire shot regions on the wafer W.

However, when transferring the pattern image of the reticle R onto each shot region of the wafer W, sometimes the exposure light IL to be emitted to the reticle R may be a linearly polarized light in a predetermined direction, depending on the pattern of the reticle R. Specifically, when the numerical aperture NA of the projection optical system PL is in excess of 0.9, it is preferable to use the exposure light IL in the state of the linearly polarized light (the degree of polarization being 80% or more). When the exposure light IL in the state of the linearly polarized light is emitted to the reticle R, for example, the 1/4 wavelength plate 19 is not used. Further, the laser beam LB emitted from the excimer laser light source 8 in this embodiment is the linearly polarized light, and the polarization direction is substantially parallel to one side of the rectangular external shape of the laser beam LB. In this case, like the first embodiment, when the external shape of the laser beam LB emitted from the excimer laser light source 8 is progressively rotated, the polarization direction of the laser beam LB incident on the illumination optical system 22 is rotated, so that the polarization direction of the exposure light IL is likely to be deviated from a desired direction on the reticle R. Although the memory/correction calculating unit 12 for controlling the rotation angle of the external shape of the laser beam LB is prepared in the excimer laser light source 8 in the embodiment, a remaining difference in controlling the rotation angle is likely to occur. Further, the rotation angle of the laser beam LB is likely to be changed in a light-sending optical path until the laser beam LB from the excimer laser light source 8 is incident on the 1/2 wavelength plate 18.

Accordingly, in this embodiment, the rotation angle monitor 10A and the detection/rotation calculating unit 11a detect the rotation angle $\theta B$ from the reference state of the external shape of the laser beam LB2, around the position where the laser beam LB enters the illumination optical system 22.

Part (A) of FIG 9 illustrates the external shape (sectional shape) of the laser beam LB being incident on the 1/2 wavelength plate 18 of FIG. 8. In part (A) of FIG. 9, a reference direction 35 is defined as the direction of the linearly polarized light component of the laser beam LB which is required to allow the direction of the linearly polarized light of the exposure light IL in the desired direction on the reticle R of FIG. 8. The external phase of the incident laser beam LB, that is, the direction 34 of the linearly polarized light component thereof, is rotated at the angle of $\theta B$ from the reference direction 35 counterclockwise. In this case, since the rotation direction of a main axis 36 of the 1/2 wavelength plate 18 is $\theta B/2$ from the reference direction 35 counterclockwise, using the rotation driving unit 20 of FIG. 8, the polarization direction of the linearly polarized light component of the laser beam LB after passing through the 1/2 wavelength plate 18 is same as the reference direction 35. Therefore, the pattern of the reticle R is transferred, with high resolution, onto the wafer W.

Further, the reference direction 35 may be determined to be suitable for, for example, the pattern of the reticle R. For example, the reference direction 35 may be determined so that a diffraction light of an S polarized light component (TE polarized light component), that is, a polarization directional component along a lengthwise direction of a line pattern, is much emitted from the pattern of the reticle R. Further, for example, when performing exposure on one lot of wafers, the rotation angle of the external shape of the laser beam LB (that is, the rotation angle of the linearly polarized light component) is detected at the lot beginning, a plurality of timings of performing exposure on each shot region of each wafer, the timing between the exposure on each shot region, or the timing of changing wafers, by using the rotation angle monitor 10A and the detection/rotation calculating unit 11 a. Then, the polarization direction of the linearly polarized light component of the laser beam LB is controlled, by rotating the 1/2 wavelength plate 18, based on the detection result.

Further, the control of the orientation of the laser light source 8 (the rotation angle of the laser beam LB) based on the detection result of the rotation angle monitor 10 may be performed, together with or independently from the control of the rotation of the 1/2 wavelength plate 18 (the polarized state of the laser beam LB) based on the detection result of the rotation angle monitor 10A. When it is difficult to perform, within a short time, the orientation control of the laser light source 8 based on the detection result of the rotation angle monitor 10, timing for each control may be determined while considering a allowable control time. For example, the orientation control of the laser light source 8 based on the detection result of the rotation angle monitor 10A and the rotation control of the 1/2 wavelength plate 18 based on the detection result of the rotation angle monitor 10A may be performed at the lot beginning (during the lot change), and only the rotation control of the 1/2 wavelength plate 18 based on the detection result of the rotation angle monitor 10A may be performed during the exposure process of the one lot of wafers (for example, 25 wafers).

Further, for example, when the exposure light IL of the circular polarized light is illuminated onto the reticle R, the 1/4 wavelength plate 19 is positioned behind the 1/2 wavelength plate 18 as exemplified in FIG. 8. Then, the 1/2 wavelength plate 18 rotates as shown in part (B) of FIG. 9, and an angle $\varphi$ to the main axis 35 of the 1/4 wavelength plate 19 in the polarization direction 37 of the linearly polarized light component of the laser beam LB is set as, for example, 45°, so that the reticle R is illuminated by the exposure light IL of a nearly perfect circular polarized light. In accordance with this embodiment, the laser beam LB may be a nearly perfect circular polarized light, by removing the 1/2 wavelength plate 18 from the optical path and controlling the rotation angle of the 1/4 wavelength plate 19.

Further, a polarization monitor for detecting the polarized state of the laser beam LB may be mounted on the exposure apparatus of FIG. 8. In this case, the 1/2 wavelength plate 18 may be rotated, based on the output of the polarization monitor.

Further, in the embodiment of FIG 8, the rotation angle of the laser beam LB is controlled by the laser light source 8, and the polarized state of the laser beam LB is controlled by the 1/2 wavelength plate positioned in front of the illumination optical system 22. However, the present invention is not limited to these. As described with reference to the first embodiment, both of the rotation angle and the polarized state of the laser beam LB may be controlled by the laser light source 8, and a structure (for example, an image rotation optical system, and the like) for controlling the rotation angle and the polarized state of the laser beam may be provided in front of the illumination optical system 22. Alternatively, a structure for controlling at least any one of the rotation angle and the polarized state of the laser beam LB may be positioned in the illumination optical system 22.

Further, in accordance with the embodiment shown in FIG. 8, both of the rotation angle and the polarized state of the laser beam LB are controlled based on the detection result of the rotation angle of the laser beam LB. However, any one of the rotation angle control and the polarized state control may be omitted without a compromise. Even if any one of the rotation angle control and the polarized state control is omitted, the polarized state of the laser beam LB (exposure light IL) can be controlled.

Further, in the embodiment of FIG. 8, either the rotation angle monitor 10, detection/rotation calculating unit 11 and memory/correction calculation unit 12 of the excimer laser light source 8, or the rotation angle monitor 10A, detection/rotation calculating unit 11a and memory/ correction calculation unit 12A may be omitted. At least any one of the rotation angle of the external shape of the laser beam LB and the rotation angle of the linearly polarized light component of the laser beam LB may be controlled, by using only the detection result of the external shape of the laser beam at any one.

Further, the projection exposure apparatus in the above-described embodiment may be manufactured, by installing a column structure (not shown), assembling the body of the exposure apparatus and the projection optical system which includes the illumination optical system with a plurality of lens and the reflection refractive system and performing the optical control, attaching the reticle stage including a number of mechanical parts and the wafer stage to the body of the exposure apparatus, connecting wires, tubes and the like, and performing the entire control (electric control, operation check, and the like). The exposure apparatus preferably may be manufactured in a clean room where temperature, cleanness, and the like are regulated.

When fabricating a semiconductor device using the projection exposure apparatus of the above-described embodiment, the semiconductor device is manufactured by the steps of: performing a design of function and performance of the device, making a reticle based on the design, forming a wafer using silicon material, performing an alignment and exposing a pattern of the reticle onto the wafer by using the projection exposure apparatus of the aforementioned embodiment, forming a circuit pattern by etching and the like, assembling the device (including a dicing process, a bonding process and a packaging process), and testing the device.

It is apparent that the present invention is applicable when exposure is performed by a batch exposure type (stop exposure type) projection exposure apparatus, such as a stepper, in addition to the scan exposure apparatus. Moreover, the present invention is applicable when exposure is performed by an immersion type exposure apparatus, for example, which is disclosed in PCT International Publication No. WO 99/49504. Further, the present invention is applicable when exposure is performed by a projection exposure apparatus which uses an extreme ultra violet (EUV) light with the wavelength of about several nanometers to 100 nanometers as an exposure beam.

Further, the application of the present invention is not limited to the exposure apparatus for the semiconductor device fabrication. For example, the present invention is widely applicable to an exposure apparatus for display devices, such as a liquid crystal display device formed on a square-shaped glass plate or a plasma display device, and an exposure apparatus to manufacture various devices, such as an image pickup device (a charge-coupled device, and the like), a micro machine, a thin-film magnetic head, a DNA chip, and the like. Further, the present invention is applicable during an exposure process (an exposure apparatus) when a mask (a photo mask, a reticle, and the like) having a mask pattern of each device is formed by a photolithography process.

Further, in the above-described embodiment, a light-transparent mask, which forms a predetermined light-shielding pattern (or phase pattern/photosensitive pattern) on a light-transparent substrate, is used. However, instead of the light-transparent mask, an electron mask may be used. For example, the electron mask, which is disclosed in U.S. Patent No. 6,778,257, forms a transparent pattern or a reflective pattern or a light-emissive pattern, based on electronic data of the pattern to be exposed.

The foregoing embodiment and advantages are merely exemplary and are not to be construed as limiting the present invention. The description of the embodiments of the present invention is intended to be illustrative, and not to limit the scope of the claims, and many alternatives, modifications, and variations will be apparent to those skilled in the art. Further, the disclosure (including the detailed description, claims, drawings and abstract) of Japanese Patent Application No. 2005-024601 filed on January 31, 2005 is hereby incorporated in this application in its entirety.

Industrial Applicability

The exposure apparatus according to the embodiment of the present invention performs high-throughput or high-resolution exposure. Accordingly, a device including a very small pattern is manufactured with high-throughput or high-resolution.

**Claims**

1. A method of controlling a laser light source performing pulse oscillation, comprising:

   a first process of detecting a rotation angle of an external shape of a laser beam emitted by the pulse oscillation from the laser light source.

2. The method according to claim 1, further comprising:

   a second process of controlling at least any one of a rotation angle of an external shape of a laser beam emitted by pulse oscillation from the laser light source and a rotation angle of a linearly polarized light component of a corresponding laser beam, based on the rotation angle which is detected in the first process.

3. The method according to claim 1 or 2, wherein the sectional shape of the laser beam is rectangular, and the first process includes a process of detecting displacement of a corner part in the sectional shape of the laser beam.

4. The method according to any one of claims 1 to 3, wherein the sectional shape of the laser beam includes a marking unit used in detecting the displacement.

5. A method of controlling a laser light source performing pulse oscillation, comprising:

   a first process of storing in advance a relation between an operation state of the laser light source and a rotation angle of an external shape of a laser beam emitted by the pulse oscillation from the laser light source; and
   a second process of controlling at least any one of a rotation angle of an external shape of a laser beam emitted by the pulse oscillation from the laser light source and a rotation angle of a linearly polarized light component of a corresponding laser beam, based on the relation being stored in the first process.

6. The method according to claim 5, wherein the detection of the rotation angle is performed in the first process by changing the operation state of the laser light source.

7. The method according to claim 6, wherein the operation state of the laser light source includes at least any one of pulse oscillation frequency and pulse energy of the laser light source.

8. A laser light source device including a laser light source for performing pulse oscillation, comprising:

   a detection system that detects a rotation angle of an external shape of a laser beam emitted by the pulse oscillation from the laser light source.

9. The laser light source device according to claim 8, further comprising:

   a control device that controls at least any one of a rotation angle of an external shape of a laser beam emitted by pulse oscillation from the laser light source and a rotation angle of a linearly polarized light component of a corresponding laser beam, based on the rotation angle detected by the detection system.

10. The laser light source device according to claim 8 or 9, wherein the sectional shape of the laser beam is rectangular, and the detection system includes an imaging device positioned so as to correspond to a corner part of the sectional shape of the laser beam.

11. The laser light source device according to any one of claims 8 to 10, further comprising:

    an aperture member that provides a marking unit used in detecting displacement with the sectional shape of the laser beam.

12. A laser light source device which includes a laser light source performing pulse oscillation, comprising:

    a memory device that stores a relation between an operation state of the laser light source and a rotation angle of an external shape of a laser beam emitted by the pulse oscillation from the laser light source; and
    a controlling device that controls at least any one of a rotation angle of an external shape of a laser beam emitted by pulse oscillation from the laser light source and a rotation angle of a linearly polarized light component of a corresponding laser beam, based on the relation stored in the memory device.

13. The laser light source device according to claim 9 or 12, wherein the control device includes: a holding structure that holds the laser light source, and a driving structure that controls orientation of a corresponding maintenance structure.

14. The laser light source device according to claim 9 or 12, wherein the control device includes a wavelength plate which is positioned on an optical path of the laser beam emitted by the pulse oscillation from the laser light source.

15. An exposure apparatus which exposes an object with an exposure beam, wherein
the exposure beam is emitted to the object and is a laser beam being output from the laser light source device of any one of claims 8 to 14.

16. An exposure apparatus which exposes an object by emitting an exposure beam to a corresponding object, comprising:

> a laser light source that emits a laser beam as the exposure beam by pulse oscillation;
> a detection system that detects a rotation angle of an external shape of the laser beam emitted by the pulse oscillation from a corresponding laser light source; and
> a control device that controls at least any one of a rotation angle of the external shape of the laser beam and a rotation angle of a linearly polarized light component of a corresponding laser beam, based on the rotation angle detected by the detection system.

17. The exposure apparatus according to claim 16, further comprising:

> an illumination optical system that emits the laser beam to a predetermined pattern,

> wherein the detection system that detects the rotation angle of the external shape of the laser beam is disposed to be proximate to a position where the laser beam enters the illumination optical system.

18. An exposure apparatus which exposes an object by emitting an exposure beam to a corresponding object, comprising:

> a laser light source that emits a laser beam as the exposure beam by pulse oscillation; and
> a control device that controls at least any one of a rotation angle of an external shape of the laser beam and a rotation angle of a linearly polarized light component of a corresponding laser beam, based on an operation state of the laser light source.

19. The exposure apparatus according to any one of claims 16 to 18, wherein the control device includes:
a holding structure that holds the laser light source, and a driving structure that controls orientation of a corresponding maintenance structure.

20. The exposure apparatus according to any one of claims 16 to 18, wherein the control device includes a wavelength plate which is positioned on an optical path of the laser beam.

21. The exposure apparatus according to any one of claims 15 to 20, wherein the laser beam is emitted to the object, in a state of a linearly polarized light.

22. A device fabricating method comprising: using the exposure apparatus of any one of claims 15 to 21.

# FIG. 1

MEMORY/CORRECTION
CALCULATING UNIT

DETECTION/ROTATION
CALCULATING UNIT

ROTATION
ANGLE
MONITOR

SA,SB

# FIG. 2

# FIG. 3

(A)

(B)

# FIG. 4

(A)

(C)

(B)

(D)

# FIG. 5

(A)  (B)  (C)  (D)  (E)

# FIG. 6

(A)

(B)

# FIG. 7

(A)

(B)

# FIG. 8

EP 1 852 948 A1

# FIG. 9

(A)

(B)

<table>
<tr><td colspan="2" align="center">**INTERNATIONAL SEARCH REPORT**</td><td>International application No.<br>PCT/JP2006/301493</td></tr>
</table>

A. CLASSIFICATION OF SUBJECT MATTER
*H01S3/13*(2006.01), *G03F7/20*(2006.01), *H01L21/027*(2006.01),
*H01S3/00*(2006.01), *H01S3/03*(2006.01)

According to International Patent Classification (IPC) or to both national classification and IPC

B. FIELDS SEARCHED

Minimum documentation searched (classification system followed by classification symbols)
*H01S3/13*(2006.01), *G03F7/20*(2006.01), *H01L21/027*(2006.01),
*H01S3/00*(2006.01), *H01S3/03*(2006.01)

Documentation searched other than minimum documentation to the extent that such documents are included in the fields searched
Jitsuyo Shinan Koho          1922-1996   Jitsuyo Shinan Toroku Koho   1996-2006
Kokai Jitsuyo Shinan Koho   1971-2006   Toroku Jitsuyo Shinan Koho   1994-2006

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y<br>A | JP 5-241324 A  (Nikon Corp.),<br>21 September, 1993 (21.09.93),<br>Par. No. [0043]; Fig. 9<br>(Family: none) | 18-22<br>1-17 |
| Y<br>A | JP 2003-014643 A  (Canon Inc.),<br>15 January, 2003 (15.01.03),<br>Par. Nos. [0007], [0077] to [0090]; Fig. 12<br>& US 2003/0043376 A1<br>Par. Nos. [0009], [0094] to [0107]; Fig. 6 | 18-22<br>1-17 |
| Y<br>A | JP 4-343307 A  (Ricoh Co., Ltd.),<br>30 November, 1992 (30.11.92),<br>Par. No. [0004]; Fig. 1<br>(Family: none) | 19-22<br>1-18 |

☒ Further documents are listed in the continuation of Box C.     ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>21 February, 2006 (21.02.06) | Date of mailing of the international search report<br>07 March, 2006 (07.03.06) |
|---|---|
| Name and mailing address of the ISA/<br>Japanese Patent Office | Authorized officer |
| Facsimile No. | Telephone No. |

Form PCT/ISA/210 (second sheet) (April 2005)

**INTERNATIONAL SEARCH REPORT**

| International application No. |
| --- |
| PCT/JP2006/301493 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 10-012957 A  (Nikon Corp.),<br>16 January, 1998 (16.01.98),<br>Par. Nos. [0023] to [0043]; Figs. 3 to 5<br>(Family: none) | 1-22 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H04196513 B
- WO 9949504 A
- US 6778257 B
- JP 2005024601 A